Europäisches Patentamt

European Patent Office

Office européen des brevets

(11) Veröffentlichungsnummer: **0 134 899**
**A1**

(12) **EUROPÄISCHE PATENTANMELDUNG**

(21) Anmeldenummer: 84105806.8

(22) Anmeldetag: 22.05.84

(51) Int. Cl.⁴: **H 01 B 7/08**
**H 05 K 3/36**

(30) Priorität: 26.07.83 DE 3326800

(43) Veröffentlichungstag der Anmeldung:
27.03.85 Patentblatt 85/13

(84) Benannte Vertragsstaaten:
AT CH GB LI NL

(71) Anmelder: ANT Nachrichtentechnik GmbH
Gerberstrasse 33
D-7150 Backnang(DE)

(72) Erfinder: Berger, Erwin
Reichenberger Strasse 24
D-3340 Wolfenbüttel(DE)

(72) Erfinder: Odernheimer, Tilo
Bürgerstrasse 6
D-3160 Hämelerwald(DE)

(74) Vertreter: Wiechmann, Manfred, Dipl.-Ing.
ANT Nachrichtentechnik GmbH Gerberstrasse 33
D-7150 Backnang(DE)

(54) Verkabelungseinrichtung.

(57) Leiterplatte, die zur Verdrahtung von Geräten auf mindestens einer ihrer Seiten Zweidraht-Leitungen (1,2,3,4) aufweist, die voneinander und von Fremd-Störfeldern entkoppelt sein sollen. Hierzu werden die Zweidraht-Leitungen (1,2,3,4) verdrillt, indem in Abständen Durchkontaktierungen (7,8,12,13) vorgesehen sind, mit deren Hilfe jeweils ein Leiter der Zweidraht-Leitungen um den anderen herumgeführt (11,11a) ist.

FIG.1

Croydon Printing Company Ltd.

0134899

Verkabelungseinrichtung

Die Erfindung betrifft eine Verkabelungseinrichtung, wie im Oberbegriff des Patentanspruches 1 angegeben. Zur Vermeidung der Einkopplung von Störungen ist es bei elektrischen Zweidrahtleitungen bekannt, deren Leiter zu verdrillen (Schröder Elektrische Nachrichtentechnik, Band 1, Verlag für Radio-Foto-Kinotechnik GmbH, 1959, Seite 243).

Bekannt ist auch ein flexibles Bandkabel, das als gedruckte Schaltung ausgeführt ist (DE-PS 899 378). Dieses Bandkabel kann als Ersatz für einen Kabelbaum zur Verbindung von Baugruppen dienen. Dabei ist ein flexibler, flacher Isolierstoffträger beidseitig mit galvanisch aufgebrachten Leitungszügen versehen. Die Leitungszüge verlaufen schräg zur Längsausdehnung des Isolierstoffträgers von einer Kante zur anderen, nämlich von Kontakten an einer Kante zu anderen Kontakten an der anderen Kante. Von dort verlaufen die Leiter auf der anderen Seite des Isolierstoffträgers weiter zu nächsten Kontakten, die wiederum an der ersten Kante des Isolierstoffträgers angebracht sind. Die galvanisch aufgebrachten Leitungen verlaufen also sozusagen wendelförmig um den flachen Isolierstoffträger herum, wodurch sich ähnliche Eigenschaften wie bei einer verdrillten Leitung ergeben, mit der Wirkung, daß die Einkopplung von Fremdfeldern reduziert ist.

Nachteilig ist dabei, daß ein beidseitig mit galvanischen Leitungsstrukturen versehener, flexibler Isolierstoffträger kostspielig in der Herstellung ist und eine Verkopplung von zueinander parallel verlaufenden Leitungen nicht vermeidbar ist.

Bekannt ist außerdem ein Bandkabel, das als Zweidrahtleitungen verdrillte isolierte Drähte enthält. Leider ist es damit in der Praxis nicht möglich, im Verlauf des Bandkabels Zwischenanschlüsse vorzusehen. Außerdem können mit diesem Bandkabel, was die gegenseitige Verkopplung von Zweidrahtleitungen betrifft, keine reproduzierbaren Verhältnisse erzielt werden; denn die Lage der durch das Verdrillen gegebenen Überkreuzungen der Leiter der Zweidrahtleitungen ist dem Zufall überlassen.

Es ist Aufgabe der Erfindung, eine preiswert herstellbare Verkabelungseinrichtung zu finden, die eine gute und reproduzierbare Entkopplung, insbesondere induktive Entkopplung auch von Fremdfeldern, ermöglicht, und zugleich Träger von Bauelementen sein kann.

Diese Aufgabe wird gelöst durch die Verkabelungseinrichtung mit den Merkmalen des Patentanspruches 1. Vorteilhafte Weiterbildungen sind in den Unteransprüchen angegeben.

Die Verkabelungseinrichtung nach der Erfindung ist besonders geeignet für die Verkabelung von Baugruppen im Tonfrequenzbereich, insbesondere wenn Studioqualität verlangt wird. Sie ist kostengünstig herstellbar. Für die Verringerung induktiver Kopplungen aber erweist es sich als besonders vorteilhaft, daß die Leiter der Zweidraht-Leitungen überwiegend auf nur einer Seite der Leiterplatte unmittelbar nebeneinander herlaufen und dabei nur eine kleine Windungsfläche zwischen ihnen liegt, so daß durch Störfelder nur schwache Störströme bzw. durch Ströme nur schwache Störfelder induziert werden. Mit Hilfe der Durchkontaktierungen kann ein Verdrillen der Leiter der Zweidraht-Leitungen an fast jeder beliebigen Stelle auf der Leiterplatte erreicht werden. Dabei ist es zum Erreichen des Verdrillens nicht notwendig, eine Zweidraht-Leitung bis an eine Kante der Leiterplatte und um diese Kante herumzuführen; Leitungsumwege werden also vermieden und das Überkreuzen kann so oft wie nötig an beliebigen Stellen und reproduzierbar erfolgen.

Die beiden Durchkontaktierungen eines Paares von Durchkontaktierungen, die einen Leiter der Zweidraht-Leitung auf die andere Seite der Leiterplatte und wieder zurückführen, liegen dicht an dem zwischen ihnen hindurchgeführten, galvanisch aufgebrachten anderen Leiter der Zweidraht-Leitung. Andere Durchkontaktierungs-Paare derselben Zweidraht-Leitung oder einer anderen sind demgegenüber wesentlich weiter entfernt.

Bevorzugt sind zwei Zweidraht-Leitungen im wesentlichen parallel zueinander geführt und eine Herumführung einer der Zweidraht-Leitungen befindet sich jeweils möglichst in der Mitte der Strecke, die zwischen zwei aufeinanderfolgenden Herumführungen der benachbarten Zweidraht-Leitung liegt.

Gegenüber der bisher in der Studiotechnik üblichen Verdrahtung mit verdrillten, geschirmten Leitungen, läßt sich der Arbeitsaufwand und die Fehlerhäufigkeit erheblich vermindern, und bezüglich der Kompensation von störenden Kopplungen zwischen einzelnen Zweidraht-Leitungen und des Einflusses von Störfeldern von anderen Quellen läßt sich eine beträchtliche Verbesserung erzielen, die sich zusätzlich durch Reproduzierbarkeit auszeichnet, so daß das bisherige Hin- und Herbiegen und Verdrehen von Leitungen solange, bis eine ausreichende Entkopplung erzielt war, unterbleiben kann. Ist nämlich mit einer der erfindungsgemäßen Leiterplatten erst einmal eine ausreichende Entkopplung von Störfeldern erreicht, so ist in der Serienfertigung sichergestellt, daß auch bei weiteren zu verdrahtenden Geräten für eine ausreichende Entkopplung gesorgt ist. Hinzu kommt noch, daß Platz eingespart werden kann, weil Steckverbinder ohne lange Lötfahnen Verwendung finden können und die Lötpunkte gut zugänglich sind. Bisher war eine gute Zugänglichkeit der Lötpunkte durch die Verdrahtung nur schwer zu erreichen.

Anhand der Zeichnungen wird die Erfindung näher erläutert und ein Ausführungsbeispiel beschrieben.

Fig. 1 zeigt die prinzipielle Anordnung von Zweidraht-Leitungen auf einer Seite (sogenannte L-Seite) einer Leiterplatte, während die

Fig. 2 und 3 ein Ausführungsbeispiel darstellen.

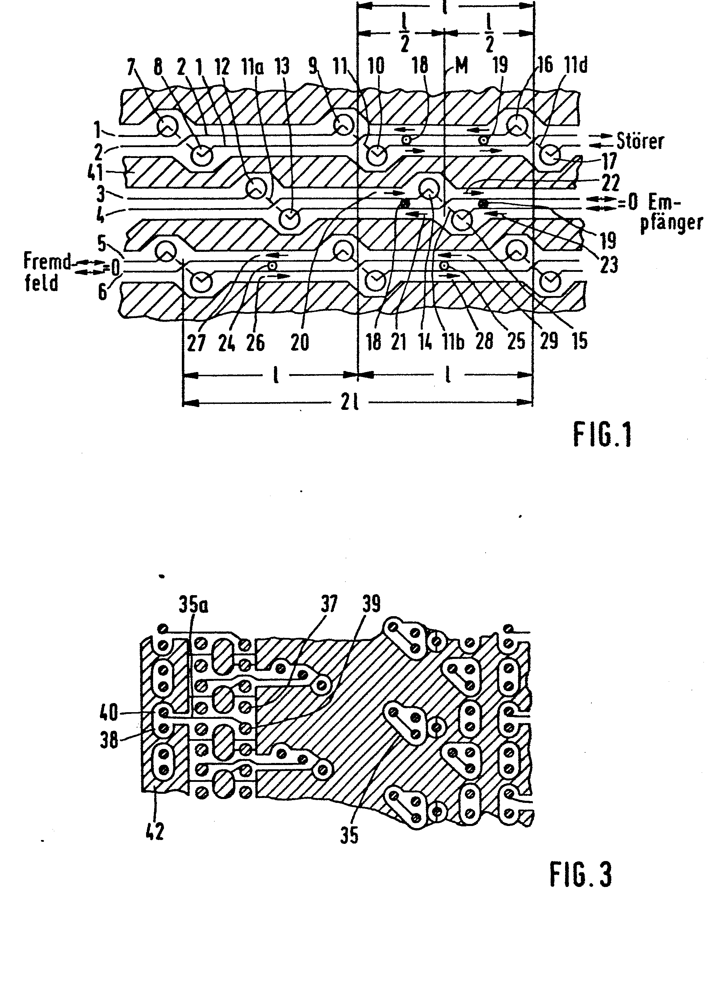

In Fig. 1 sind drei Zweidraht-Leitungen mit ihren Leitern 1 bis 6 dargestellt. Der Leiter 1 führt von links zu einer ersten Durchkontaktierung 7, wo er auf die Rückseite (sogenannte B-Seite) der Leiterplatte, also in eine unterhalb der Zeichenebene liegende Ebene geführt wird. Auf der B-Seite wird der Leiter 1 als Leiterbahn (als unterbrochene Linie gezeichnet) um den Leiter 2 herum bis zu einer Durchkontaktierung 8 geführt, wo er wieder in die Zeichenebene, also auf die L-Seite der Leiterplatte auftaucht. Zwischen dem Paar von Durchkontaktierungen 7, 8 ist der andere Leiter 2 hindurchgeführt, der rechts von diesen Durchkontaktierungen nun in der Zeichnung oberhalb des Leiters 1 verläuft. Damit ist ein erstes Überkreuzen der Leiter 1 und 2 erreicht. Ein weiteres Überkreuzen findet weiter rechts an Durchkontaktierungen 9 und 10 statt, wo diesmal der Leiter 2 zunächst mit Hilfe der Durchkontaktierung 9 in eine andere Ebene, dann als Leiterbahn 11 auf der B-Seite um den Leiter 1 herumgeführt und schließlich durch die Durchkontaktierung 10 wieder auf die L-Seite der Leiterplatte geführt ist.

Durch die Aneinanderreihung solcher Überkreuzungen ist ein Verdrillen der Zweidraht-Leitung 1, 2 erreicht. Entsprechendes gilt für die anderen Zweidrahtleitungen 3, 4 und 5, 6.

Bemerkenswert ist, daß bei den nebeneinander verlaufenden Zweidrahtleitungen 1, 2 und 3, 4 die Paare von Durchkontaktierungen 7, 8 und 12, 13 gegeneinander in Längsrichtung der Zweidraht-Leitungen versetzt sind. Ideal wäre es, wenn ein Paar von Durchkontaktierungen 14, 15 einer Zweidraht-Leitung genau in der Mitte M der Strecke 1 zwischen zwei aufeinanderfolgenden Paaren von Durchkontaktierungen 9, 10 und 16, 17 der benachbarten Zweidraht-Leitung 1, 2 liegen würde. Dann würden nämlich magnetische Feldlinien 18, 19, die in einem Leitungsabschnitt der Länge 1 zwischen zwei aufeinanderfolgenden Paaren von Durchkontaktierungen 9, 10 und 16, 17 der Zweidraht-Leitung 1, 2 erzeugt werden, zwar zwischen den Leitern 3, 4 der benachbarten Zweidraht-Leitung als Feldlinien 18, 19 hindurchtreten und in dieser Spannungen entsprechend den Pfeilen 20 bis 23 induzieren; aber in Folge der Überkreuzung durch die Durchkontaktierungen 14, 15 würden sich die Spannungspfeile 21 und 22 sowie 20 und 23 gegenseitig kompensieren.

Dies gilt allerdings nur unter der idealisierten Vorstellung, daß die Zweidraht-Leitungen vollkommen parallel zueinander verlaufen, die Abstände ihrer Leiter konstant sind usw.. In der Praxis genügt es meist, wenn die Überkreuzung an den Durchkontaktierungen 14, 15 ungefähr im mittleren Drittel der Strecke 1 liegt.

Bezüglich des Einflusses von Fremdfeldern, also von Feldern, die nicht von benachbarten Zweidraht-Leitungen induziert worden sind, ist es günstig, wenn das Muster der Aufeinanderfolge von Verdrillungen einer Zweidraht-Leitung im wesentlichen regelmäßig ist. Dies läßt sich anhand der Zweidraht-Leitung 5, 6 in Fig. 1 zeigen. Hier sind Feldlinien 24, 25 eines magnetischen Fremdfeldes angedeutet, die zwischen den Leitern 5 und 6 hindurchtreten. Sie induzieren Spannungspfeile 26, 27 bzw. 28, 29, die sich auf den zugehörigen Leitern 5, 6 gegenseitig kompensieren, wenn die von den Leitern eingeschlossene Fläche auf den Strecken 1 jeweils gleich groß und das Fremdfeld homogen ist. Bei konstantem Abstand zwischen den Leitern 5 und 6 bedeutet dies, daß die Strecke 21 durch die mittlere Überkreuzung halbiert ist. Eine Abweichung von dieser Regel ist unschädlich, wenn sie

auf weiteren Leitungsabschnitten kompensiert wird. Es ergibt sich dann zumeist ein regelmäßiges Muster von aufeinanderfolgenden Verdrillungen oder Überkreuzungen einer Zweidraht-Leitung.

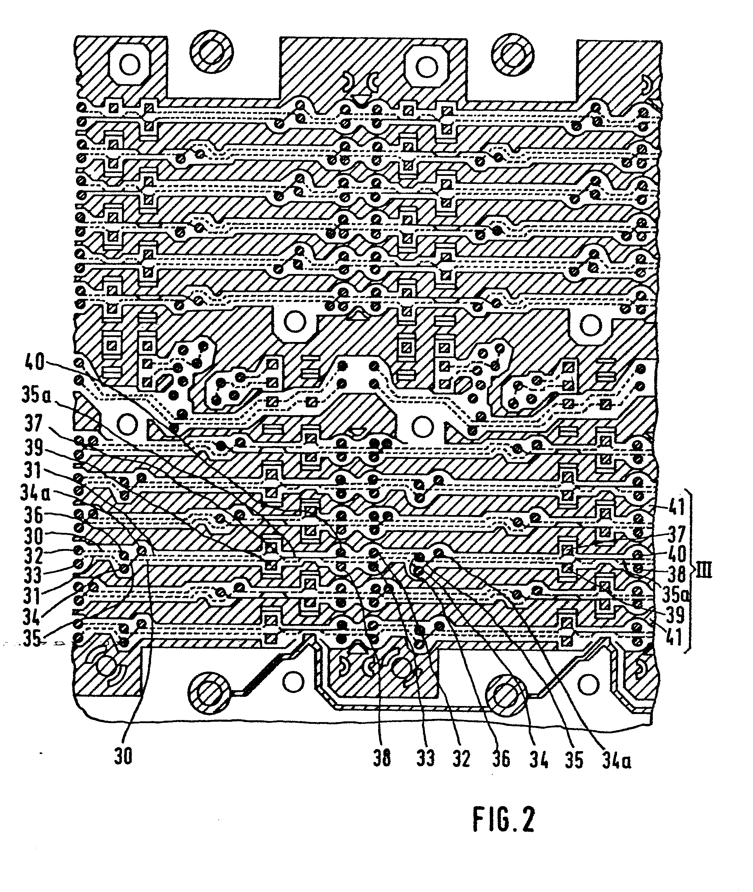

Die Fig. 2 und 3 zeigen ein praktisches Beispiel. Dabei zeigt Fig. 3 ein Stück der Rückseite (B-Seite) der Leiterplatte, deren Vorderseite (L-Seite) in Fig. 2 dargestellt ist; es handelt sich um das in Fig. 2 mit III bezeichnete Stück. Die Leiterzüge auf der L-Seite sind schraffiert dargestellt, während die auf der B-Seite durchgezogen sind. Eine Zweidraht-Leitung mit Leitern 30, 31 beginnt links an Durchkontaktierungen 32, 33. Der Leiter 31 ist zunächst bis zu einer Durchkontaktierung 34 geführt, durch welche er auf die B-Seite gelangt, wo er als Leiterbahn 35 um den auf der L-Seite gebliebenen Leiter 30 herumgeführt ist. Mit Hilfe einer Durchkontaktierung 34a gelangt der Leiter 31 wieder auf die L-Seite. Eine Durchkontaktierung 36 im Verlaufe des Leiters 30 hat lediglich die Funktion eines Lötauges. Hier kann also ein Bauelement angelötet werden. Diese Funktion haben auch die Durchkontaktierungen 32, 33 und weitere Durchkontaktierungen 37, 38, während ein weiteres Paar von Durchkontaktierungen 39, 40 u.a. zum Überkreuzen der Leiter 30, 31 dient.

Im weiteren Verlauf der Zweidraht-Leitung wiederholt sich das bisherige Muster von Durchkontaktierungen und damit verbundenen Überkreuzungen; dies ist dadurch angedeutet, daß im weiteren Leitungsverlauf die gleichen Positionsziffern, die für den bisherigen Leitungsverlauf verwendet wurden, wiederholt sind.

Es ist ersichtlich, daß bei dem gezeigten Ausführungsbeispiel bei zwei nebeneinander geführten Zweidraht-Leitungen die Herumführungen 35 eines Leiters um den anderen so gegeneinander versetzt sind, daß solche Herumführungen der einen

BK 83/77
0134899

Zweidraht-Leitung immer gerade neben einem Leitungsabschnitt der anderen Zweidraht-Leitung liegen, in welchem die beiden Leiter ungestört nebeneinander herlaufen.

Es sei bemerkt, daß auch eine einseitig mit Leiterbahnen versehene Leiterplatte benutzt werden kann, wenn die Herumführungen 35 als Drahtbrücken ausgeführt sind.

Schließlich sei noch auf zusätzliche Leiterbahnen 41 hingewiesen, die auf der L-Seite der Leiterplatte angeordnet sind, also in derselben Ebene, in welcher die Zweidraht-Leitungen hauptsächlich laufen. Diese zusätzlichen Leiterbahnen 41 beanspruchen weitgehend den Zwischenraum zwischen einander benachbarten Zweidraht-Leitungen. Sie werden auf Massepotential gelegt und dienen als Abschirmung zwischen den Zweidraht-Leitungen.

Schließlich sind auch auf der B-Seite (Fig. 3) zusätzliche Leiterbahnen 42 vorgesehen, die ebenfalls als Abschirmungen dienen und deshalb mit Massepotential verbunden werden. Sie hinterlegen die Zweidraht-Leitungen auf der L-Seite der Leiterplatte mit abschirmender Wirkung.

- - - - -

0134899

ANT Nachrichtentechnik GmbH
Gerberstr. 33
D-7150 Backnang


Patentansprüche


1. Verkabelungseinrichtung mit Zweidraht-Leitungen, deren Leiter zur Entkopplung von Störquellen mit Hilfe von Überkreuzungen verdrillt sind, die nach einem im wesentlichen regelmäßigen Muster der Aufeinanderfolge vorgesehen sind, dadurch gekennzeichnet,
   - daß sie als Leiterplatte ausgebildet ist, die mit Steckverbindern oder anderen Bauelementen bestückt ist und bei der mindestens eine Zweidraht-Leitung (3, 4; 30, 31) derart als Leiterbahnenpaar ausgebildet ist, daß deren Leiter unmittelbar nebeneinander auf einer Seite der Leiterplatte überwiegend in derselben Ebene verlaufen,
   - daß an den Überkreuzungen jeweils vorgesehen sind:
      a) eine Herausführung (12; 34) eines Leiters (3; 31) aus der Ebene mittels einer Durchkontaktierung eines Paares von Durchkontaktierungen,
      b) eine Herumführung (11a; 35) um den dort in der Ebene verbleibenden anderen Leiter (4; 30) und
      c) eine Zurückführung (13; 34a) in die Ebene mittels der anderen Durchkontaktierung und
   - daß die beiden Durchkontaktierungen dieses Paares von Durchkontaktierungen dichter an dem zwischen ihnen hindurchgeführten anderen Leiter der Zweidraht-Leitung liegen als andere Paare von Durchkontaktierungen derselben Zweidraht-Leitung oder einer anderen.


2. Verkabelungseinrichtung nach Anspruch 1, dadurch gekennzeichnet, daß mindestens zwei nebeneinander als Leiterbahnenpaar geführte Zweidrahtleitungen (1, 2; 3, 4) vorgesehen sind, in deren Längsrichtungen die jeweiligen
Herumführungen (11; 11a) gegeneinander versetzt sind.

3. Verkabelungseinrichtung nach Anspruch 1 oder 2, dadurch
gekennzeichnet, daß als Herumführung eine Drahtbrücke
auf der anderen Seite der Leiterplatte vorgesehen ist.

4. Verkabelungseinrichtung nach Anspruch 1 oder 2, dadurch
gekennzeichnet, daß als Herumführung eine Leiterbahn (11)
auf der anderen Seite der Leiterplatte vorgesehen ist.

5. Verkabelungseinrichtung nach einem der Ansprüche 2 bis 4,
dadurch gekennzeichnet, daß zwischen den beiden nebeneinander geführten Zweidrahtleitungen (1, 2; 3, 4) in derselben Ebene eine den gegenseitigen Zwischenraum weitgehend beanspruchende Leiterbahn (41) vorgesehen ist.

6. Verkabelungseinrichtung nach einem der vorangehenden Ansprüche, dadurch gekennzeichnet, daß die Zweidraht-Leitung (30, 31) auf der anderen Seite der Leiterplatte
durch eine Leiterbahn (42) hinterlegt ist.

7. Verkabelungseinrichtung nach einem der Ansprüche 2 bis
5, dadurch gekennzeichnet, daß zwei Zweidraht-Leitungen
(1, 2; 3, 4) im wesentlichen parallel zueinander verlaufen und eine Herumführung (11b) einer der Zweidrahtleitungen (3, 4) jeweils im mittleren Drittel der Strecke
(1) angeordnet ist, die zwischen zwei aufeinanderfolgenden Herumführungen (11, 11d) der benachbarten Zweidraht-
Leitung (1, 2) liegt.

8. Verkabelungseinrichtung nach einem der vorangehenden Ansprüche, dadurch gekennzeichnet, daß das Muster der Aufeinanderfolge von Überkreuzungen (34, 34a, 35; 39, 35a,
40) einer Zweidraht-Leitung (30, 31) im wesentlichen
regelmäßig ist.

**FIG.1**

**FIG.3**

**FIG.2**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| P,X | US-A-4 418 239  (LARSON et al.)  <br> *  Spalte  2, Zeile 1 - Spalte 3, Zeile 18, Figur 1 * | 1,3-5 | H 01 B   7/08 <br> H 05 K   3/36 |
| | --- | | |
| X | DE-A-2 709 129  (SIEMENS) <br><br> * Ansprüche 1,2,4; Seite 3, Zeile 1  -  Seite 4, Zeile 21; Seite 6, Zeile 5  -  Seite  8,  Zeile 11; Figuren 1-3 * | 1,3-5, 8 | |
| | --- | | |
| A | DE-A-2 939 925  (LICENTIA) <br><br> *  Seite  6,  Zeile 30 - Seite 8, Zeile 3; Figur 1 * | 1,3,4, 8 | |
| | ----- | | |

**RECHERCHIERTE SACHGEBIETE (Int. Cl. ³)**

H 01 B   7/08
H 01 B   11/04
H 05 K   3/36

Der vorliegende Recherchenbericht wurde für alle Patentansprüche erstellt.

| Recherchenort <br> BERLIN | Abschlußdatum der Recherche <br> 22-10-1984 | Prüfer <br> HAHN G |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82